(19) Europäisches Patentamt
European Patent Office
Office européen des brevets

(11) **EP 1 018 136 B1**

(12) **EUROPÄISCHE PATENTSCHRIFT**

(45) Veröffentlichungstag und Bekanntmachung des Hinweises auf die Patenterteilung:
**28.07.2004 Patentblatt 2004/31**

(21) Anmeldenummer: **98932028.8**

(22) Anmeldetag: **29.04.1998**

(51) Int Cl.$^7$: **H01J 37/02**

(86) Internationale Anmeldenummer:
**PCT/DE1998/001186**

(87) Internationale Veröffentlichungsnummer:
**WO 1998/050938 (12.11.1998 Gazette 1998/45)**

(54) **ABBILDENDE UND/ODER ABTASTENDE VORRICHTUNG MIT EINER KOMPENSIERUNG VON, DURCH DIE UMGEBUNG VERURSACHTER ABBILDUNGSVERSCHLECHTERUNGEN**

IMAGING AND/OR RASTER-MODE SCANNING SYSTEM PROVIDED WITH A DEVICE FOR COMPENSATING THE IMAGE DEGRADATIONS RESULTING FROM ENVIRONMENTAL FACTORS

DISPOSITIF D'IMAGERIE ET/OU DE BALAYAGE LIGNE PAR LIGNE DOTE D'UN DISPOSITIF DE COMPENSATION DES DEGRADATIONS D'IMAGE DUES AUX FACTEURS ENVIRONNEMENTAUX

(84) Benannte Vertragsstaaten:
**DE FR GB NL**

(30) Priorität: **03.05.1997 DE 19718799**

(43) Veröffentlichungstag der Anmeldung:
**12.07.2000 Patentblatt 2000/28**

(73) Patentinhaber: **Heiland, Peter**
**65479 Raunheim (DE)**

(72) Erfinder: **Heiland, Peter**
**65479 Raunheim (DE)**

(74) Vertreter: **Blumbach, Kramer & Partner GbR**
**Patentanwälte,**
**Alexandrastrasse 5**
**65187 Wiesbaden (DE)**

(56) Entgegenhaltungen:
**WO-A-92/03840**

- **PATENT ABSTRACTS OF JAPAN vol. 097, no. 004, 30. April 1997 & JP 08 321274 A (HITACHI LTD), 3. Dezember 1996**
- **PATENT ABSTRACTS OF JAPAN vol. 013, no. 254 (E-772), 13. Juni 1989 & JP 01 052369 A (HITACHI LTD), 28. Februar 1989**
- **PATENT ABSTRACTS OF JAPAN vol. 017, no. 412 (P-1583), 30. Juli 1993 & JP 05 079811 A (NIKON CORP), 30. März 1993**
- **PATENT ABSTRACTS OF JAPAN vol. 014, no. 065 (E-0884), 6. Februar 1990 & JP 01 286244 A (HITACHI LTD), 17. November 1989**
- **PATENT ABSTRACTS OF JAPAN vol. 018, no. 475 (E-1601), 5. September 1994 & JP 06 162982 A (HITACHI LTD), 10. Juni 1994**

**Beschreibung**

Die Erfindung betrifft eine abbildende und/oder in einem Rastermodus abtastende Vorrichtung nach dem Oberbegriff des Anspruches 1 und ein Verfahren zum Betrieb einer derartigen Vorrichtung. Es sollen Umgebungseinflüsse, die Abbildungsverschlechterungen verursachen können, kompensiert werden.

Abbildende und/oder in einem Rastermodus abtastende Vorrichtungen, beispielsweise Rasterelektronenmikroskope, Kraftmikroskope und Lichtrastermikroskope haben bei vielen Prüfverfahren von Proben eine große Bedeutung erlangt.

Diese Messungen werden jedoch häufig durch äußere Umgebungsbedingungen so beeinflußt, daß die Abbildungsqualität herabgesetzt wird. Daraus resultiert unter Umständen eine unerwünschte Verschlechterung des Auflösungsvermögens bzw. eine fehlerhafte Abbildung. Eine derartige Abbildungsverschlechterung wird im folgenden allgemein als Auftreten von Abbildungs- oder Bildfehlern beschrieben. Eine die Abbildungsqualität mindernde Einflußgröße kann bei Elektronenrastermikroskopen beispielsweise ein elektromagnetisches Störfeld sein, welches auf die Elektronenbahnen Einfluß nimmt. Ferner kommen Luft- und/oder Bodenschwingungen in der Umgebung des Mikroskops in Betracht, durch die Ortsunschärfen bei der Beleuchtung der Probe bzw. bei der Erfassung der Elektronen verursacht werden. Der beschriebene Einfluß von elektromagnetischen Störfeldern bzw. Luft- und/oder Bodenschwingungen auf die Abbildungsqualität gilt prinzipiell für alle abbildende und/oder in einem Rastermodus abtastende Vorrichtungen.

Ein Verfahren, um Störungen infolge Luft- und/oder Bodenschwingungen zu eliminieren, besteht darin, die zu schützende Vorrichtung auf eine aktive Schwingungsisolationseinrichtung zu stellen. Derartige Einrichtungen weisen Aktuatoren auf, die die zu schützende Vorrichtung abstützen und dabei im Gegentakt zu auftretenden Schwingungen angesteuert werden, um so die Vorrichtung von den Schwingungen zu isolieren.

Ein Elektronenmikroskop mit einer derartigen aktiven Schwingungsisolationseinrichtung ist aus der JP 08 321 274 bzw. aus dem Patent Abstracts of Japan Vol. 097, Nr. 004 bekannt. Die vertikalen Vibrationen werden mit Sensoren festgestellt, die an einer Trägerplatte des Elektronenmikroskops sitzen, und in horizontaler Richtung 20 auftretende Störungen werden durch einen Bildvergleich mittels eines Bildabtastsensors ermittelt.

Die Vibrationsabschätzung mittels Bildbearbeitungsverfahren bei einem Elektronenmikroskop ist aus JP 01 052 369 A bzw. den Patent Abstracts of Japan, Vol. 013, Nr. 254 (E 772) bekannt. Das digitale Bildsignal wird gegenüber Vibrationen entzerrt und gespeichert. Bei realen Objekten werden Differentiationsverfahren angewendet, um die Vibrationsfrequenz mit der höchsten Amplitude festzustellen.

Bei einem Rastermikroskop (JP 07 079 811 A bzw. Patent Abstracts of Japan, Vol. 017, Nr. 412 (P 1583) weist der Probenhalter des Rastermikroskops einen Vibrationsdetektor auf, dessen Signale einer Molding Filter Schaltung zugeführt werden, die mit einer digitalen Bildentstörungsschaltung verbunden ist, welche außerdem Datensignale von einer Sonden-Abtastschaltung und einer Feststellungs- und Servoschaltung empfängt, um die störende Vibrationskomponente aus der beobachteten Information der Probenoberfläche zu entfernen.

Ein Elektronenmikroskop mit Abtastung der Vibration des festgestellten Bildes ist aus JIP 01 286 244 A bzw. Patent Abstracts of Japan, Vol. 014, Nr. OI65 (E 884)bekannt. Ein Speicher für die Größe der Bildverzerrung einer Referenzprobe wird zum Vergleich der Verzerrung mit einer realen Probe benutzt und die Abtastung der realen Probe wird demgemäß korrigiert.

Bei einem Rasterelektronenmikroskop nach JP 06 162 982 A bzw. Patent Abstracts of Japan, Vol. 018, Nr. 475 (E 1601) sind ein Vibrationsdetektor und eine Regelschaltung vorgesehen, welche die Strahlablenkeinrichtungen dahingehend beeinflusst, um die relative Verschiebung zwischen dem Elektronenstrahl und der Probe infolge der Vibration klein zu halten.

Aus der WO 92 03 840 A ist eine abbildende und/oder in einem Rastermodus arbeitende Vorrichtung nach dem Oberbegriff des Anspruchs 1 bekannt bei der die Regelschaltung einen Integrator und ein Phasenkompensationsnetzwerk enthält die als Filter wirken. Es wird die Einstellung des Abtastmusters eines Elektronenstrahls in dem Rasterelektronenmikroskop beeinflusst, so dass die Bildempfindlichkeit gegenüber Vibrationen verringert wird.

Keines dieser Dokumente offenbart ein digitales Filter, dessen Kennlinie auf die jeweiligen Einflüsse der Umgebung zur Minimierung der Störungen über einen gesonderten Eingang eingestellt wird.

Aufgabe der Erfindung ist es somit, eine Vorrichtung nach der Gattung des Anspruchs 1 bereitzustellen, bei der Umgebungseinflüsse, die Abbildungsverschlechterungen oder -fehler verursachen können, wirkungsvoll kompensiert werden.

Die gestellte Aufgabe wird durch eine Vorrichtung nach Anspruch 1 und ein Verfahren zum Betrieb einer derartigen Vorrichtung nach Anspruch 18 gelöst.

Danach durchläuft ein von den Umgebungseinflüssen abhängiges erstes. Signal ein einstellbares digitales elektrisches Filter und steuert ein internes Stellglied an, das auf die Abbildung einwirkt, wobei im kalibrierten Zustand der Vorrichtung, der durch Einstellung der Übertragungsparameter, d.h. der Übertragungskennlinie des Filters realisiert wird, die Bildverschlechterung stark vermindert oder im wesentlichen kompensiert ist. Durch das Einstellen des Filters kann sichergestellt werden, dass die Kompensation der die Abbildung störenden Umgebungseinflüsse im Gegensatz zu Vorrichtungen nach dem Stand der Technik "am eigentlichen Ort des Geschehens" stattfindet. Die Erfindung läßt sich in einer Vielzahl von Ausführungsformen nutzen. Dabei kann der Aufwand vom benötigten Grad der Kompensation der Umgebungseinflüsse abhängig gemacht werden.

Beispielsweise kann das digitale Filter zum Kalibrieren der Vorrichtung einen Kalibriereingang aufweisen, an dem ein zweites Signal zum Einstellen der Übertragungsparameter des Filters angelegt wird, oder das Filter kann eine Einrichtung zum manuellen Einstellen der Übertragungsparameter aufweisen. Liegt ein Ausgangssignal der Bildverarbeitungseinrichtung am Kalibriereingang des Filters an, so kann in Abhängigkeit der erfaßten Bildfehler die Übertragungsparameter des Filters derart abgestimmt werden, daß genau die Störung kompensiert wird, die auf die Abbildung einwirkt und nicht die Störung an einem Ort in der Nähe der Vorrichtung.

Das von den Umgebungseinflüssen abhängige erste Signal, welches am Signaleingang des Filters anliegt, kann entweder durch einen Sensor zur Erfassung mindestens einer physikalischen Größe außerhalb der Vorrichtung abgegeben werden, oder ein Ausgang der Bildverarbeitungseinrichtung ist mit dem Kalibriereingang des Filters verbunden, so daß das Kalibriersignal beispielsweise von einer Bildanalyse abhängt. Wird ein Sensor zur Abgabe des ersten Signals verwendet, lassen sich elektromagnetische und/oder magnetische Felder, Luftschwingungen und/oder Körper- bzw. Bodenschwingungen erfassen. In vorteilhafter Weise kann eine Störgröße, aber auch mehrere gleichzeitig aufgenommen werden und die durch die Störgröße hervorgerufenen Abbildungsfehler durch Ansteuerung eines oder mehrerer Stellglieder kompensiert werden.

Die hohe Flexibilität der Erfindung zeigt sich auch darin, daß die erfindungsgemäße Einwirkung auf die Abbildung und/oder auf die Bilddarstellung in Abhängigkeit der Störgrößen auf vielfältige Weise stattfinden kann. Als interne Stellglieder lassen sich vorhandene Ablenksysteme oder Verstellungen von Probetischen benutzen. Zusätzlich zu den internen Stellgliedern, die der Probeabtasteinrichtung zugeordnet sind, lassen sich darüber hinaus als weitere Aktuatoren alle Systeme verwenden, die wie Kraftaktuatoren oder Wegantriebe schwingungssensibel sind, um ein weiteres Korrektursignal aufzubringen. Außerdem besteht die Möglichkeit, die Kompensation der Abbildungsfehler durch Ansteuern eines internen Stellgliedes in der Bildverarbeitungseinrichtung zu realisieren, ohne auf die fehlerhafte Abbildung selbst Einfluß zu nehmen. Dieses Stellglied in der Bildverarbeitungsrichtung umfaßt dabei beispielsweise einen verstellbaren Parameter für eine Berechnung in der Bildverarbeitungseinrichtung. Die Verwendung von mehrachsigen Sensoren und Stellgliedern ermöglicht vorteilhafterweise die Kompensation der Störungen in mehreren Raumrichtungen. Zu diesem Zweck kann beispielsweise das Kalibriersignal am Filter in Abhängigkeit vom Abtastort und/oder von der Zeit variieren.

In einer vorteilhaften Ausführungsform wird die Vorrichtung, beispielsweise ein Mikroskop, in einem Kalibrier- und nachfolgend in einem Bildmodus betrieben, wobei im Kalibrierbetrieb Umgebungseinflüsse, die die Abbildung verschlechtern, durch das Abbilden eines vorgegebenen Referenzobjektes und Vergleichen des Bildes mit der realen Struktur des Referenzobjektes erfaßt und durch Abgleich stark vermindert oder im wesentlichen kompensiert werden, und wobei die Abbildungsfehler durch Beibehaltung des Abgleichs im bildgebenden Betrieb auch bei einer Veränderung der Umgebungseinflüsse kompensiert werden.

Durch den Vergleich des Bildes mit der realen Struktur eines Referenzobjektes wird die Kompensation der störenden Umgebungseinflüsse auf der Grundlage des objektiv vorliegenden Abbildungsfehlers durchgeführt. Damit lassen sich ferner zusätzlich zu den Umgebungseinflüssen auch systematische Abbildungsfehler der Vorrichtung erfassen und eliminieren. Während geringere Schwankungen der Störgröße automatisch kompensiert werden, kann stark veränderten Umgebungsbedingungen, beispielsweise durch einen neuen Standort des Mikroskops hervorgerufen, leicht durch einen Kalibrierzyklus Rechnung getragen werden, in welchem ein neuer, den veränderten Bedingungen angepaßter Abgleich der Vorrichtung durchgeführt wird. In vorbestimmten zeitlichen Abständen kann die Vorrichtung neu kalibriert werden, womit automatisch auch nicht offensichtliche Änderungen der Umgebungsbedingungen berücksichtigt werden.

Der Kalibrierbetrieb zeichnet sich dadurch aus, daß eine Korrelation zwischen dem jeweiligen erfaßten Abbildungsfehler und dem durch einen Sensor erfaßten Störeinfluß hergestellt wird. Im Umkehrschluß bedeutet dies, daß von einem durch einen Sensor außerhalb der Vorrichtung erfaßten Störeinfluß auf den durch diesen Störeinfluß hervorgerufenen Abbildungsfehler geschlossen und dieser Abbildungsfehler kompensiert werden kann. Ferner kann durch eine externe Ansteuerung der Probeabtasteinrichtung der Vorrichtung ein ausgewählter Abschnitt des Referenzobjektes, z. B. entlang eines Kreises, mehrmals in zeitlichen Abständen erfaßt werden. Auf diese Weise werden auch zeitlich veränderliche Abbildungsfehler, beispielsweise durch eine Gebäudeschwingung hervorgerufen, erkannt. Durch Variation des Abtastweges, beispielsweise durch Verändern des Abtastradius, können weiterhin ortsabhängige Abbildungsfehler, d. h. Abbildungsfehler, die vom Abtastort des beispielhaften Rastermikroskopes abhängen, erfaßt werden. Somit ist die erfindungsgemäße Vorrichtung zur Erfassung und Kompensation von orts- und zeitabhängigen Abbildungsfehlern eingerichtet.

Im Bildbetrieb wird nun die eigentliche Probe durch Abtasten vollständig erfaßt, wobei das zweite Signal zum Einstellen der Übertragungskennlinie des Filters unter Zugrundelegen der während des Kalibrierbetriebs ermittelten Daten abgeleitet wird.

In einer weiteren vorteilhaften Ausführungsform ist die Vorrichtung zur automatischen Kalibrierung des Filters während des Bildbetriebs eingerichtet. Im Gegensatz zur vorhergehenden Ausführungsform wird die Kalibrierung während des normalen Bildmodus durchgeführt. Somit wird beispielsweise der übliche Mikroskopierablauf nicht gestört, da kein Wechsel zwischen einer Probe und dem Referenzobjekt durchgeführt werden muß. Neben dem Vorteil des geringeren Zeitbedarfs spricht die Vorrichtung direkt auf eine möglicherweise unbemerkte Änderung der Störgröße an und kalibriert sich durch Einstellung der Übertragungskennlinie des Filters neu, wobei das am Kalibriereingang des Filters angelegte Signal aus einer Bildanalyse in der Bildverarbeitungseinrichtung abgeleitet ist. Durch eine zeilenmäßige Bildanalyse läßt sich beispielsweise rekursiv die Verschiebung der Zeilenschwerpunkte aufeinanderfolgender Bilddzeilen innerhalb des Gesamtbildes bestimmen und ein zweites Signal aus dieser zeitlichen Verschiebung zur Ansteuerung des Kalibriereingangs des Filters berechnen. Die Pixelverschiebungen des Zeilenschwerpunktes dient somit als Amplitude der Bildstörung. Die Zeilenfrequenz erlaubt eine Zuordnung von Zeit und Frequenz für eine Korrelationsbetrachtung bei der aktiven Aufschaltung eines von der Störgröße abhängigen Kompensationssignals, d. h. bei der Ansteuerung eines Aktuators und/oder einer Stellgröße, die auf die Abbildung und/oder die Bilddarstellung einwirken. Wird parallel zur ermittelten Störamplitude zu jedem Zeilenanfang ein außerhalb der Vorrichtung angeordneter Sensor zur Erfassung eines Umgebungseinflusses, welcher die Abbildung verschlechtert, eingelesen, so ermöglicht dies die gleichzeitige Aufnahme von Bildstörung und der diese verursachende externe Störeinfluß. Dieses Verfahren erlaubt somit eine direkte Berechnung der Übertragungsfunktion des Filters, die benötigt wird, um die Störung zu kompensieren. Alternativ können prinzipielle Annahmen, z.B. bezüglich der Anzahl der Pole und Nullstellen der Übertragungsfunktionen getroffen werden, und mit der Bildanalyse Einzelparameter, d.h. beispielsweise die Pole und Nullstellen, iterativ optimiert werden. Die zeilenmäßige Bildanalyse erlaubt die Einstellung des Filters und damit die Kompensation der die Abbildungsfehler hervorrufenden Umwelteinflüsse bis zu einer Frequenz, die nach dem Nyquist-Theorem der halben Erfassungsfrequenz entspricht.

Die Bildanalyse kann auch die rekursive Bestimmung der Verschiebung des Bildschwerpunktes aufeinanderfolgender Bilder umfassen. Dies bietet sich beispielsweise für Transmissionselektronenmikroskope oder Lichtmikroskope an, die zur Darstellung eines Objektes ein Kamerasystem verwenden. Durch die Ermittlung der Verschiebung des Bildschwerpunktes in zwei zueinander orthogonalen Achsen lassen sich so, über eine entsprechende Korrelation mit den Störgrößen, durch Ansteuerung entsprechender Aktuatoren und/oder Stellglieder die Bildfehler in zwei zueinander senkrechte Richtungen beheben. Die angesprochenen Kamerasysteme arbeiten herkömmlicherweise zwischen 25 und 70 Hz. Obwohl die Auswertung und damit auch die Kompensation wegen der Digitalisierung auf die halbe Bildwiederholrate reduziert ist, kann bei grundsätzlicher Kenntnis der Übertragungsfunktion zwischen Störgröße und Bildstörung durch Extrapolation die eigentliche Übertragungsfunktion auch über den vorgegebenen Frequenzrahmen hinaus bestimmt werden. Dies ermöglicht die Kompensation durch die Kompensationsgrößenaufschaltung auch bei Frequenzen, die größer als die Bildfrequenz des verwendeten Kamerasystems sind.

Bei einer weiteren Ausführungsform der Erfindung wird nicht nur der Kalibriereingang des Filters von der Bildverarbeitungseinrichtung gespeist, sondern auch der Eingang des Filters für das erste Signal. Somit kann auf den vorwärts geschalteten Sensor verzichtet werden. Es werden die aus der Bildanalyse gewonnene Verschiebungen in zwei zueinander orthogonalen Richtungen auf das interne Stellglied zurückgeführt.

Die Erfindung kann in einer Vielzahl von abbildenden und/oder in einem Rastermodus abtastenden Vorrichtungen Verwendung finden, die sich zum Herstellen oder Betrachten bzw. Vermessen von Oberflächen eignen, beispielsweise Raster-Elektronenmikroskope, Kraftmikroskope, Oberflächenrauhigkeitsmeßgeräte, optische Rastermikroskope, Lichtmikroskope, Transmissionselektronenmikroskope oder Lithographieanlagen.

Schon bestehende Anlagen können durch einfaches Nachrüsten zu erfindungsgemäßen Vorrichtungen zur Kompensation von Umgebungseinflüssen ausgestattet werden.

Die Erfindung wird im folgenden auf der Grundlage einiger Ausführungsbeispiele unter Bezugnahme auf die anliegenden Zeichnungen beschrieben, von denen:

Fig.1a bis 1d     verschiedene Ausführungsformen der Erfindung in Form von Blockschaltbilder zeigt,

Fig. 2     ein erfindungsgemäßes Rastermikroskop schematisch darstellt,

Fig. 3     ein beispielhaftes Referenzobjekt darstellt, wie es für den Kalibrierbetrieb des Mikroskops der Fig. 2 Verwendung finden kann,

Fig. 4     ein beispielhaftes Signal S der Bilderfassungseinrichtung zeigt, wenn das Mikroskop der Fig. 2 im Kalibrierbetrieb ein Referenzobjekt auf einem vorgegebenen Weg entsprechend der Koordinate x zu verschiedenen Zeiten abtastet und erfaßt,

Fig. 5     die beispielhafte Korrelation zwischen der Verschiebung der Zeilenschwerpunkte, welche durch eine Kurve dargestellt wird, mit dem zeitlich entsprechenden Verlauf einer außerhalb der Vorrichtung erfaßten Störgröße, welche die Verschiebung der Zeilenschwerpunkte verursacht,

Fig.6a     bis 6c die Verschiebung des Bildschwerpunktes dreier aufeinanderfolgender Bilder zeigt,

Fig. 7    den zeitlichen Verlauf der Verschiebung des Schwerpunktes aus Fig. 6 für die x-Richtung zeigt und

Fig. 8    eine beispielhafte Ausführungsform eines optischen Mikroskops darstellt, die dem Blockschaltbild der Fig. 1c entspricht.

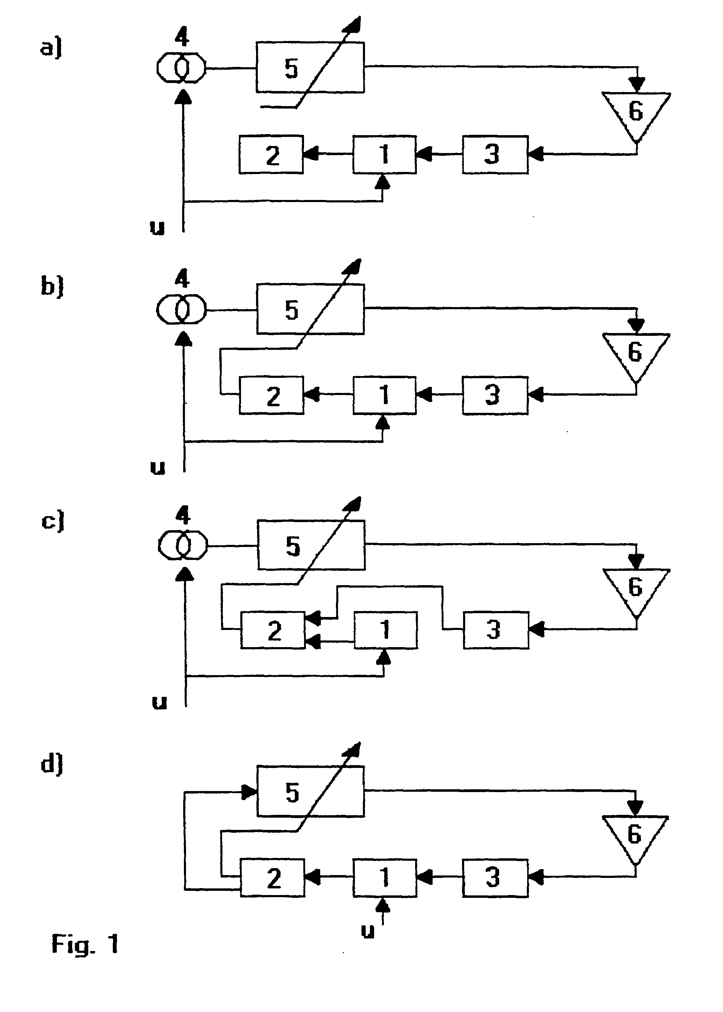

Fig. 1a stellt eine erste Ausführungsform der erfindungsgemäßen abbildenden und/oder in einem Rastermodus abtastenden Vorrichtung als Blockschaltbild schematisch dar. Die Ziffer 1 bezeichnet eine Einrichtung in Form eines Rasterelektronenmikroskops, d.h. ohne eine Kompensationseinrichtung zur Kompensation von Umgebungseinflüssen, welche die Abbildung verschlechtern können. Die Vorrichtung umfaßt einen Sensor 4 außerhalb der Einrichtung 1, wobei dieser Sensor 4 ein erstes Signal, das vom elektromagnetischen Störfeld am Ort des Sensors abhängt, an ein digitales Filter 5 abgibt, das einen zweiten Eingang zur manuellen Einstellung der Übertragungskennlinie des Filters aufweist. Eine Störung U wirkt sowohl auf den Sensor 4 als auch auf die Einrichtung 1 ein, was hier wie in den Figuren 1b bis 1d, durch die von U ausgehenden Pfeile angedeutet ist. Nach dem Durchlaufen des Filters 5 und der Verstärkung in einem nachgeschalteten Regelverstärker 6 liegt ein Kompensationssignal an einem internen Stellglied 3 an, das von den Ablenkspulen des Elektronenstrahls des Rasterelektronenmikroskops gebildet wird. Der Regelverstärker 6 dient zum Anpassen des Ausgangssignals des Filters 5 an das interne Stellglied 3. Das Kompensationssignal ist ein Signal, welches von der Störgröße, also dem elektromagnetischen Störfeld, abhängt und wird auf das eigentliche Ansteuerungssignal der Ablenkspulen aufgeschaltet. Die Anordnung des Sensors "außerhalb" der Einrichtung 1 bedeutet, dass durch Ansteuern des internen Stellgliedes kein wesentlicher Einfluß auf das Meßsignal des Sensors 4 ausgeübt wird. Durch das Kalibrieren des Filters 5 wird erreicht, daß das aufgeschaltete Kompensationssignal für die Bilderfassung gerade einer entgegengesetzten Wirkung entspricht, welche das elektromagnetische Störfeld am Ort der Einrichtung 1 hervorruft und sich somit die Auswirkung der Kompensationssignalaufschaltung und die Wirkung des störenden elektromagnetischen Feldes auf die Abbildung im wesentlichen aufheben. Bei einem Standortwechsel des Rasterelektronenmikroskops muß zur Modellierung der Übertragungsfunktion das Filter jeweils neu kalibriert werden.

Fig. 1b zeigt ein Blockschaltbild einer zweiten Ausführungsform der erfindungsgemäßen Vorrichtung, bei welcher die Kalibrierung des Filters 5 mittels eines zweiten Signals aus einer Bildverarbeitungseinrichtung 2 durchgeführt wird.

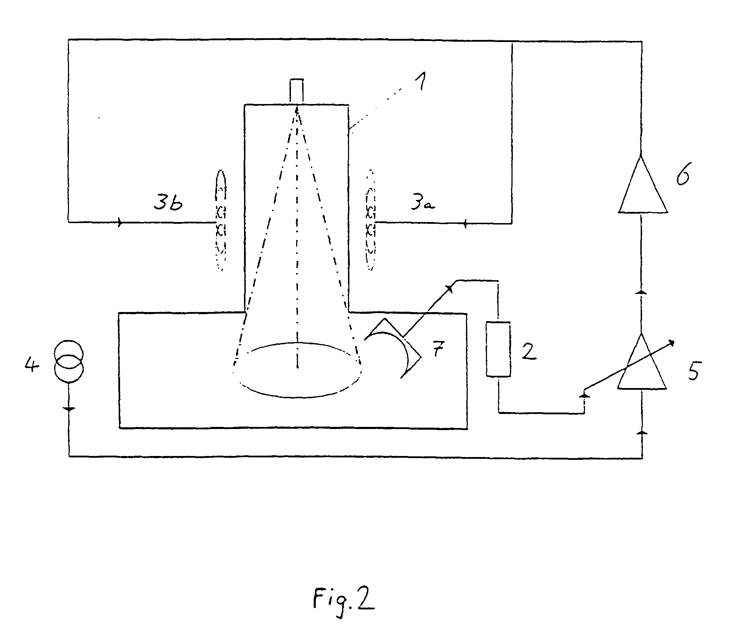

In Fig. 2 ist eine derartige Vorrichtung als Rasterelektronenmikroskop mit einem Anschluß der Bildverarbeitungseinrichtung 2 an den Kalibriereingang des Filters 5 gezeigt. Eine Bilderfassungseinrichtung 7 erfaßt zumindest einen Bildpunkt des Objektes und speist die Bildverarbeitungseinrichtung 2. Wie bei der ersten Ausführungsform wird das Signal des Sensors 4 auf die Ablenkspulen 3a, 3b vorwärtsgekoppelt. In der Bildverarbeitungseinrichtung 2 wird das Signal zum Ansteuern des Kalibriereingangs des Filters 5 erzeugt. Das Kalibrieren des Filters 5 wird im folgenden mit Bezug auf zwei unterschiedliche Ausführungsvarianten beschrieben.

Nach der ersten Variante ist das Mikroskop zum Betrieb in einem Kalibrier- und einem Bildmodus eingerichtet, wobei im Kalibrierbetrieb Umgebungseinflüsse, die die Abbildungsqualität mindern, durch das Abbilden eines vorgegebenen Referenzobjektes und Vergleichen des Bildes mit der realen Struktur des Referenzobjektes erfaßt und durch Abgleich des Mikroskops im wesentlichen aufgehoben werden. Die Abbildungsfehler werden auch bei einer Veränderung der Umgebungseinflüsse durch Beibehaltung des Abgleichs im Bildbetrieb stark vermindert oder im wesentlichen kompensiert. Je nach Betriebsmodus hängt das Eingangssignal des Kalibriereingangs des Filters 5 entweder vom jeweiligen gemessenen Abbildungsfehler ab (Kalibriermodus) oder wird mittels der während des Kalibriermodus gespeicherten Daten gewonnen (Bildmodus). Zwischen dem Kalibrier- und Bildbetrieb kann hin- und hergeschaltet werden.

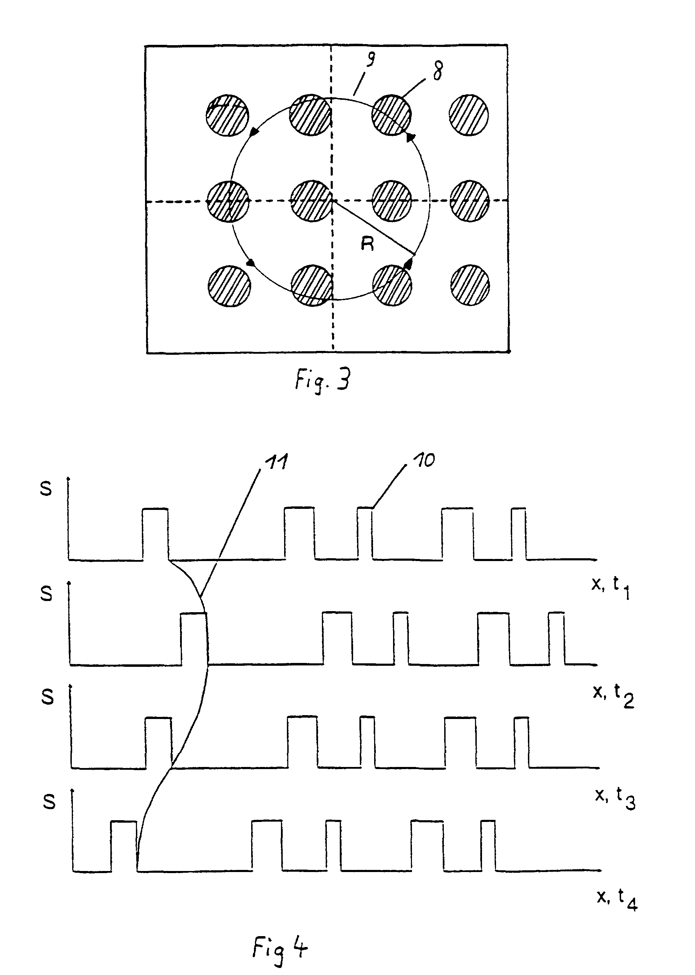

Der Kalibriermodus wird genutzt, um Umgebungseinflüsse, d. h. in diesem Fall das elektromagnetische Störfeld, das die Abbildungsqualität mindert, durch das Abbilden eines vorgegebenen Abschnittes eines Referenzobjektes und Vergleichen des Bildes mit der realen Struktur des Referenzobjektes zu erfassen und die Vorrichtung derart abzugleichen, daß durch äußere Umgebungsbedingungen verursachte und/oder apparativ bedingte, systematische Abbildungsfehler im wesentlichen kompensiert werden. Dieser Abgleich des Mikroskops wird durch Einstellen der Übertragungskennlinie des Filters durchgeführt. In Fig. 3 ist dargestellt, wie im Kalibrierbetrieb die Abtasteinrichtung einen ausgewählten Abschnitt eines Referenzobjektes abtastet, wobei in der digitalen Bildverarbeitungseinrichtung 2 ein gespeichertes, dem Referenzobjekt zugeordnetes Signal mit dem von der Bilderfassungseinrichtung 7 erhaltenen Bildsignal des Referenzobjektes verglichen und ein dem Unterschied zugeordneten Signal gebildet wird, welches an den Kalibriereingang des Filters 5 abgegeben wird.

Das Abgleichverfahren im Kalibriermodus läßt sich durch folgende Schritte beschreiben:

- Ermitteln eines ersten Signals, das vom elektromagnetischen Störfeld am Ort des Sensors 4 abhängt, durch den Sensor 4;
- Anlegen des ersten Signals an den Signaleingang des Filters 5 ;
- Erfassen eines ausgewählten Abschnittes eines vorgegebenen Referenzobjektes mit einer Bilderfassungseinrichtung 7 durch Abtasten des Referenzobjektes;

- Vergleichen des erfaßten Bildes mit der realen Struktur des Referenzobjektes;
- Ermitteln eines dem Unterschied zugeordneten Fehlersignals;
- Anlegen des vom Fehlersignal abgeleiteten zweiten Signals an den Einstelleingang des Filters 5 zur Festlegung von dessen Übertragungskennlinie;
- Anlegen des Ausgangssignals des Filters 5 an den Signaleingang des Regelverstärkers 6 ;
- Anlegen des Ausgangssignals des Regelverstärkers 6 an die Ablenkspulen 3a, 3b des Elektronenstrahls zur Korrektur der verminderten Bildqualität;
- iterativer Abgleich der Kennlinie des Filters 5, derart, daß die Verminderung der Abbildungsqualität stark vermindert oder im wesentlichen kompensiert wird, durch die Schritte:

  - Vergleich des korrigierten Bildes mit der realen Struktur des Referenzobjektes;
  - derartiges Verändern der Übertragungskennlinie des Filters 5, das sich das korrigierte Bild der realen Struktur des Referenzobjektes nähert;
  - Abspeichern von Daten zur Erzeugung der ermittelten Übertragungsfunktion des Filters 5 für den Bildbetrieb.

Diese Daten zur Erzeugung der ermittelten Übertragungsfunktion des Filters 5 für den Bildbetrieb werden in einer Ausführungsform in einem der Bildverarbeitungseinrichtung 2 zugeordneten Speicher abgespeichert. In einer weiteren Ausführungsform ist der Filter 5 zur Speicherung dieser Daten eingerichtet. Während der Bestimmung des Abbildungsfehlers sind die Einrichtungen zur Kompensation der Abbildungsfehler abgeschaltet. Danach wird das Rasterelektronenmikroskop mit dem vorstehend beschriebenen Verfahren abgeglichen, d.h. die Vorwärtskopplung für das Meßsignal des Sensors als Maß für die Störgröße eingestellt. Die Qualität der Kompensation wird dabei durch mehrmaliges Abtasten des Referenzobjektes und Vergleichen des Bildes mit der realen Struktur des Referenzobjektes gemessen. Durch das jeweilige Bestimmen der Qualität der Kompensation und dem entsprechenden Verändern der Übertragungsfunktion des Filters wird die Vorwärtskopplung iterativ derart verändert, daß die Abbildungsfehler des Rasterelektronenmikroskops minimiert werden.

Das Mikroskop kann bezüglich örtlich und/oder zeitlich veränderlicher Abbildungsfehler abgeglichen werden.

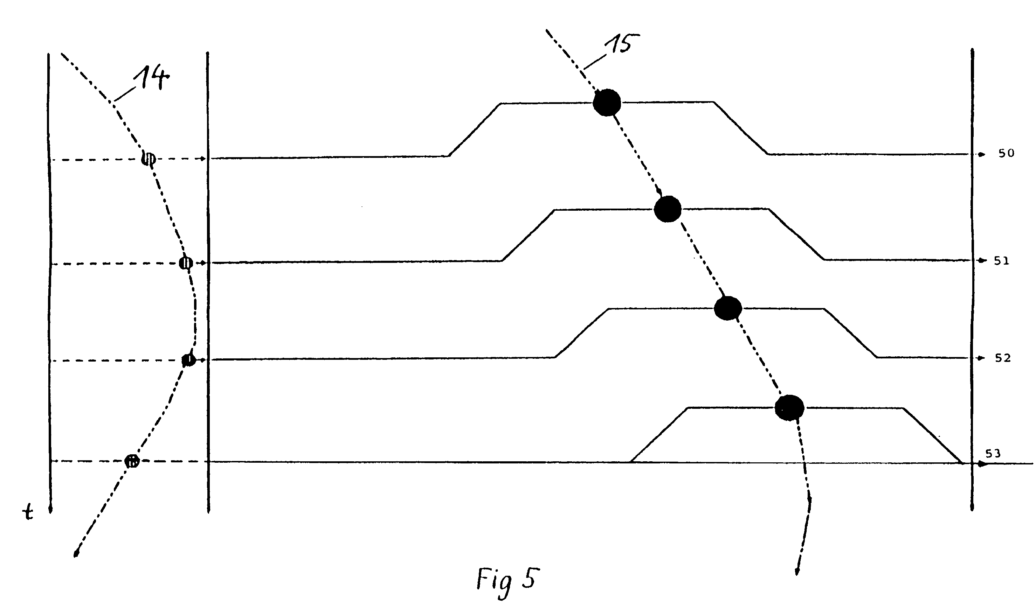

Hierzu wird im Kalibriermodus ein wie in Fig. 3 beispielhaft gezeigtes Referenzobjekt auf einem vorgegebenen Weg 9 abgetastet. Das abgebildete Referenzobjekt umfaßt Einzelobjekte 8, die auf einer Unterlage abgeschiedene, kreisförmige Goldablagerungen darstellen, die in einer vorgegebenen Art und Weise angeordnet sind. Durch eine externe Ansteuerung der Abtasteinrichtung des Mikroskops wird ein ausgewählter Abschnitt des Referenzobjekts erfaßt. Dieser Weg 9 kann geschlossen sein. Auf diesem geschlossenen Weg 9 liegen die Einzelobjekte 8, auf welche die Bilderfassungseinrichtung 7 anspricht und ein Signal ungleich Null erzeugt. Dies ist schematisch und beispielhaft in Fig. 4 gezeigt, in welcher der zu einem gegebenen Zeitpunkt $t_1$ erfaßte Signalverlauf 10 beim Durchlaufen der geschlossenen Kurve 9 dargestellt ist. Zeitabhängige Störungen können zeitabhängige Abbildungsfehler verursachen. Aus diesem Grund wurde in der Darstellung der Fig. 4 die geschlossene Kurve zeitlich beabstandet viermal durchlaufen. Die resultierenden vier Signalverläufe 10 sind somit auch ein Maß für die zeitliche Änderung der Störung. Ferner wird die durchlaufene Kurve durch Variieren des Radius R verändert, womit sich ortsabhängige Abbildungsfehler erfassen lassen. Durch Vergleichen des Bildes in der Bildverarbeitungseinrichtung 2 mit dem genau bekannten, vorgegebenen Referenzobjekt wird der zeit- und/oder ortsabhängige Abbildungsfehler bestimmt. In dem in Fig. 4 wiedergegebenen Beispiel wird der zeitabhängige Abbildungsfehler durch die Kurve 11 dargestellt.

Der Bildbetrieb ist die Betriebsart des Rasterelektronenmikroskops, bei der die eigentliche Probe gemessen wird. Die im Kalibriermodus bestimmte Übertragungskennlinie des Filters 5 ist während des darauffolgenden Bildbetriebs bezüglich der im Kalibrierbetrieb festgelegten Kennlinie unveränderlich. Wie vorstehend dargelegt, kann sie jedoch zeitlich und in Abhängigkeit von dem Abtastort variieren.

Unter der Annahme einer im wesentlichen konstanten Korrelation zwischen dem elektromagnetischen Störfeld und dem durch diese Störgröße hervorgerufenen Abbildungsfehler wird das Ausgangssignal des Filters 5 nach Durchlaufen des Regelverstärkers 6 auf das interne Stellglied 3, d.h. die Ablenkeinheiten 3a, 3b des Elektronenstrahls aufgeschaltet, so daß Bildfehler auch bei Veränderung der Umgebungseinflüsse, d.h. der Stärke des elektromagnetischen Störfeldes, im wesentlichen kompensiert werden.

In einer weiteren Ausführungsform werden zusätzlich zu den elektromagnetischen Störfeldern auch Luftschwingungen und/oder Bodenschwingungen durch geeignete Sensoren 4 erfaßt, die abgegebenen Signale durchlaufen kalibrierbare und den jeweiligen Störungen zugeordnete Filter 5 mit einstellbaren Übertragungskennlinien und werden nach einer zusätzlichen Anpassung im Regelverstärker 6 dem internen Stellglied 3, d.h. der Ablenkeinheit und/oder anderen Aktuatoren als weiteres Steuersignal aufgeschaltet, so daß auch die durch Luftschwingungen und/oder Bodenschwingungen hervorgerufenen Abbildungsfehler stark vermindert oder im wesentlichen kompensiert werden.

In der zweiten Variante wird die Notwendigkeit vermieden, zwischen verschiedenen Betriebsmodi der Vorrichtung hin- und herschalten zu müssen. Die Vorrichtung nach der zweiten Variante ist zur automatischen Kalibrierung des Filters während des Bildbetriebs eingerichtet. Zur Vereinfachung der Darstellung wird diese Ausführungsform wieder in Bezug auf ein Raster-Elektronenmikroskop beschrieben, sie ist jedoch nicht darauf beschränkt. Die Vorrichtung umfaßt im wesentlichen die Komponenten des vorhergehend beschriebenen Raster-Elektronenmikroskops mit der Ausnahme, daß in der Bildverarbeitungseinrichtung das erfaßte Bild analysiert und ein von der Analyse abhängiges Signal als zweites Signal an den Kalibriereingang des Filters 5 angelegt wird. Diese Bildanalyse umfaßt in der beispielhaften Ausführungsform die rekursive Bestimmung der Verschiebung der Zeilenschwerpunkte aufeinander folgender Bildzeilen innerhalb des Gesamtbildes. Die Analyse beruht auf der Erkenntnis, daß Bilder von Objekten in abbildenden und/oder abtastenden Vorrichtungen im allgemeinen aufgrund der Einflußnahme der Störgrößen auf die Abbildung zeitlich nicht stabil sind. In Fig. 5 ist zur Erläuterung der Verlauf der Helligkeit innerhalb von vier ausgewählten Bildzeilen dargestellt, wobei die Schwerpunkte der Helligkeitsverteilung in jeder Zeile mit je einem schwarzen Kreis gekennzeichnet sind und die Kurve 15 die zeitliche Verschiebung dieses Schwerpunktes bei zeitlich nacheinander abgetasteten Zeilen verdeutlicht. Den jeweiligen Zeilenerfassungszeitpunkten entsprechend ist auf der linken Seite der Betrag einer beispielhaften Störgröße, welche die entsprechende Pixelverschiebung des Schwerpunktes innerhalb der Zeilen verursacht als Kurve 14 aufgetragen. Auf diese Weise läßt sich eine Korrelation zwischen der Störgröße und dem durch diese Störgröße verursachten Abbildungsfehler herstellen. Die Pixelverschiebung des Zeilenschwerpunktes von einer Bildzeile zur nächsten dient als Amplitude der Bildstörung. Die Zeilenfrequenz erlaubt eine Zuordnung von Zeit und Frequenz für die Korrelation bei der aktiven Kompensationssignalaufschaltung des vorwärtsgekoppelten Signals. Wird parallel zur Ermittlung dieser Pixelverschiebung zu jedem Zeilenanfang der externe Sensor eingelesen, kann eine zeitparallele bzw. gleichzeitige Erfassung der Bildstörung und des diese Störung verursachenden Störeinflusses vorgenommen werden. Prinzipiell ist damit unter der Annahme einer ausreichenden Kohärenz die direkte Berechnung der am Filter 5 einzustellenden Übertragungsfunktion möglich, um die Bildstörung im wesentlichen zu kompensieren. In einer alternativen Ausführungsform werden prinzipielle Annahmen bezüglich der Pole und Nullstellen der Übertragungsfunktion des Filters getroffen und die Einzelparameter der variabel gestalteten Funktionen iterativ optimiert.

Im folgenden wird ein beispielhaftes Verfahren zur Ermittlung der Schwerpunktverschiebung aufeinanderfolgender Zeilen kurz skizziert. Aufgrund des Abtasttheorems können Störfrequenzen kompensiert werden, die kleiner als die halbe Abtastfrequenz sind. Ferner setzt das Verfahren voraus, daß einzelne Objekte innerhalb des Bildes sehr viel größer als der Zeilenabstand sind und daß Schwerpunktsverschiebungen senkrecht zur Abtastrichtung im Bild klein sind im Vergleich zu Schwerpunktsverschiebungen parallel zur Zeilenrichtung. Außerdem wird angenommen, daß der Unterschied der Intensität $\varepsilon_n(t)$ von benachbarten Zeilen gering ist, und die Intensität $f_{n+1}$ der Zeile n+1 geschrieben werden kann:

$$f_{n+1}(t) = f_n(t) + \varepsilon_n(t) \,.$$

Wird dieses Sytem nun gestört, ergibt sich die gestörte Intensität $d_n(t)$ unter der Annahme, daß die Störung innerhalb der Zeile eine zeitliche Verschiebung $\Delta_n$ der Bildelemente verursacht durch:

$$d_{n+1}(t) = t_{n+1}(t+\Delta_{n+1}) = f_n(t+\Delta_{n+1}) + \varepsilon_n(t+\Delta_{n+1})$$

und

$$d_{n+1}(t) = d_n(t+\Delta_{n+1} - \Delta_n) + \varepsilon_n(t+\Delta_{n+1}).$$

Unter der Verwendung eines nicht kausalen Wiener-Filters läßt sich ein δ-Puls in Abhängigkeit der Zeilenverschiebungen $\Delta_{n+1}$ und $\Delta_n$ berechnen:

$$\delta(t + \Delta_{n+1} - \Delta_n) \approx FFT^{-1}(D_{n+1}(\omega)\, D^*_n(\omega) / |D_n(\omega)|^2 + \sigma^2_\varepsilon \} \,,$$

wobei $D_n(\omega)$ die Fourier-Transformierte der gestörten Intensität $d_n(t)$ ist. Diese δ-Funktion hängt von dem Unterschied der Schwerpunktverschiebung benachbarter Zeilen ab. Somit läßt sich rekursiv die Schwerpunktverschiebung innerhalb der Zeilen eines Bildes berechnen, da $(\Delta_{n+1} - \Delta_n)$ wie obenstehend erläutert, durch die Bildanalyse bekannt ist. Zur Ansteuerung der Ablenkeinheit des Mikroskops wird unter Verwendung einer Vektorkorrelation ein Signal erzeugt, welches proportional der Korrelationsfunktion der gemessenen Störgröße und der berechneten Schwerpunktsverschiebungen in den einzelnen Zeilen ist. Diese Korrelation wird im digitalen Filter durchgeführt, wobei am Kalibriereingang des Filters ein zweites Signal anliegt, welches von der berechneten zeitlichen Verschiebung abhängt.

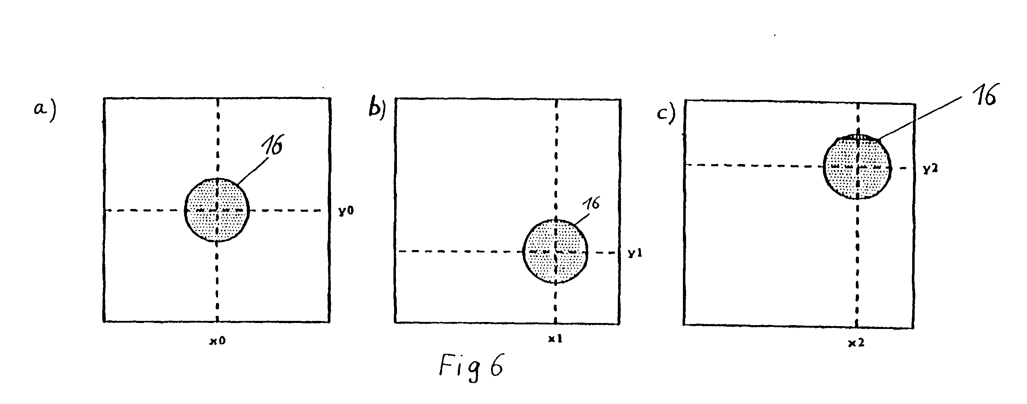

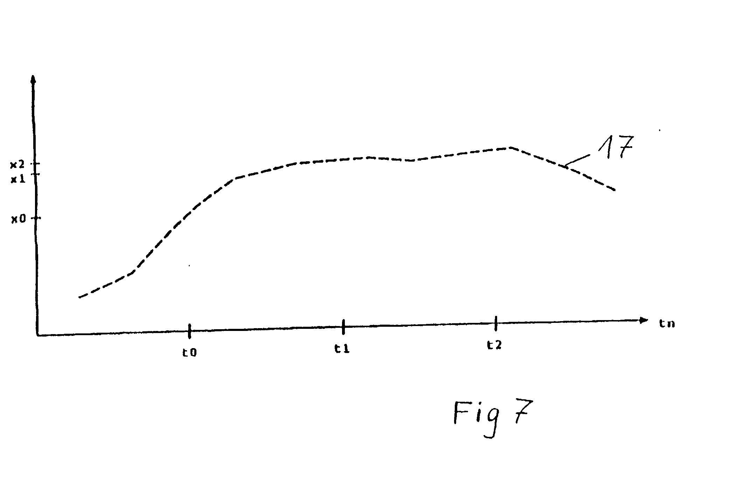

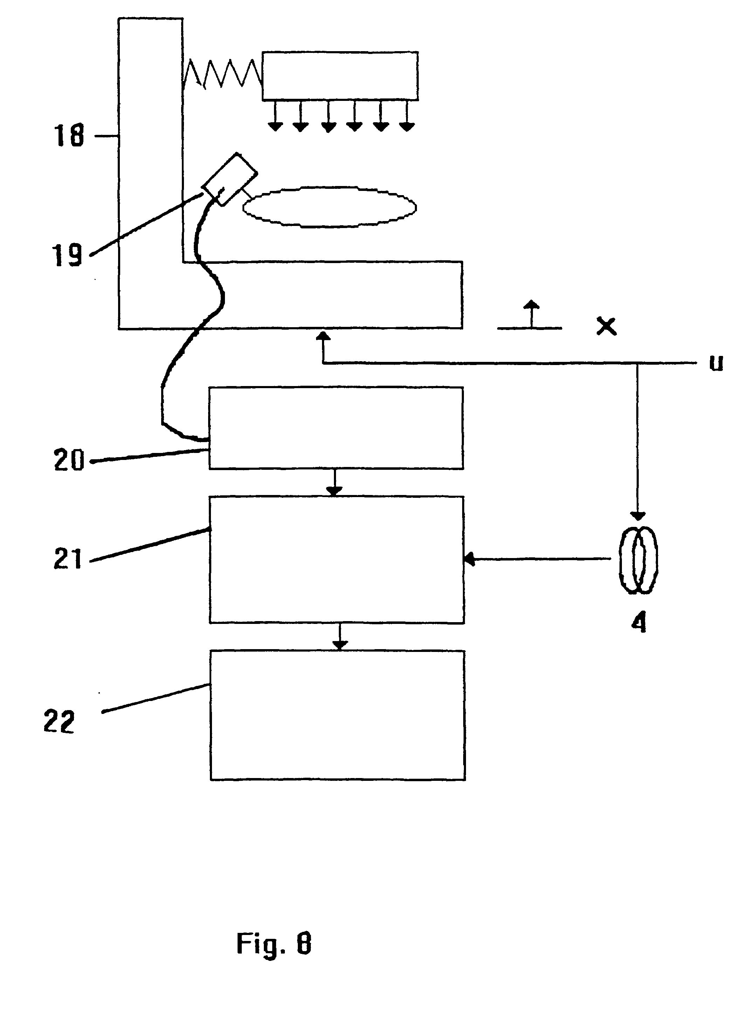

Eine dritte Ausführungsform der Erfindung eignet sich beispielsweise für Transmissionselektronenmikroskope (TEM) oder Lichtmikroskope oder artverwandte Einrichtungen, die zur Darstellung des Objekts ein Kamerasystem 20 (Fig. 8) verwenden. Die in Fig. 1c im Blockschaltbild dargestellte Einrichtung 1 entspricht dem in Fig. 8 dargestellten optischen Mikroskop 18. Der externe Sensor 4 ist als mehrachsiger Schwingungssensor ausgeführt, dessen Signal über ein einstellbares Filter 5 und einen Verstärker 6 an ein internes Stellglied 3 geführt wird, welches in der Ausführungsform nach Fig. 8 direkt der Bildverarbeitungseinrichtung 21 zugeordnet ist und in dieser auf das Bild einwirkt. Diese Bildverarbeitungseinrichtung 21 enthält das Filter 5, den Verstärker 6 und das interne Stellglied 3 in integraler Weise. Somit wird mit einem Kompensationssignal direkt auf die Bilddarstellung Einfluß genommen. Das Kamerasystem 20 umfaßt eine CCD-Kamera 19 mit einem Monitor, wobei mit einer Bildfrequenz von 25 Hz gearbeitet wird. Die Bildverarbeitungseinrichtung 21 ist zum Abspeichern aufeinander folgender Bilder eingerichtet. Durch Bildanalyse wird die Verschiebung des Bildschwerpunktes aufeinanderfolgender Bilder in zwei zueinander orthogonalen Richtungen berechnet und zum Einstellen der Übertragungsfunktion des digitalen Filters 5 in ähnlicher Weise wie in der vorhergehend beschriebenen Ausführungsform verwendet. Eine veranschaulichende Darstellung dieser Verschiebung des Schwerpunktes aufeinanderfolgender Bilder ist in Fig. 6 und 7 gezeigt. Die Kurve 17 der Fig. 7 zeigt den Verlauf der Koordinate x des Schwerpunktes mit der Zeit. Die Differenzen zwischen zwei Abtastpunkten, z. B. $t_0$ und $t_1$, entspricht somit der Bildwiederholfrequenz.

In einer weiteren Ausführungsform wird im Vergleich zur vorhergehend beschriebenen Ausführungsform ermöglicht, Störungen durch die Kompensationssignalaufschaltung auch bei Frequenzen zu korrigieren, die größer als die Bildwiederholfrequenz von 25 Hz sind. Zu diesem Zweck wird die Übertragungsfunktion, welche durch die Resonanzstellen im mechanischen Aufbau des Mikroskops festgelegt ist, als Filter 5 implementiert. Eine Fußpunktvibration X erzeugt in dieser Weise eine Relativbewegung $\Delta x$ am Mikroskop. Damit ist die generelle Übertragungsfunktion durch die eigentliche Empfindlichkeit $\Delta x/X$ , die Resonanzfrequenz $f_R$ und durch den Parameter Q, der den asymptotischen Abfall von $\Delta x/X$ zu hohen Frequenzen festlegt, vollständig bestimmt. Mittels der Ermittlung von drei Punkten der Kurve auch unterhalb der Resonanzfrequenz $f_R$ kann somit auf die gesamte Funktion geschlossen werden und diese in der Vorwärtsregelung durch Aufschaltung eines Kompensationssignals auch für Störfrequenzen, die größer als die Bildwiederholfrequenz sind, benutzt werden.

Bei einer vierten Ausführungsformen nach Fig. 1d wird die Möglichkeit genutzt, die Bildinformation in einer klassischen Rückkopplung zur Kompensation von Bildstörungen zu verwenden. Der Sensor 4, dessen Signal in Fig. 1a, 1b und 1c vorwärtsgekoppelt wird, entfällt und statt dessen werden die ermittelten Schwerpunktsverschiebungen in x- bzw. y-Achse aus der Bildanalyse (anstelle des Signals des Sensors 4) nach Durchlaufen eines Filters 5 mit einstellbarer Übertragungsfunktion in ein geeignetes internes Stellglied, hier eine Verschiebeeinrichtung der Probe, zurückgeführt.

In weiteren, hier nicht weiter dargestellten Ausführungsformen der Erfindung kann die Vorrichtung ein Kraftmikroskop, ein Oberflächenrauhigkeitsmeßgerät, ein optisches Raster-Mikroskop oder eine Lithographieanlage sein.

Je nach Ausführungsform umfassen die angesteuerten internen Stellglieder bei Elektronenmikroskopen die schon beschriebene Ablenkeinrichtungen des Elektronenstrahls und/oder interne Stellglieder in der Bildverarbeitungseinrichtung, und bei optisch arbeitenden Vorrichtungen umfassen die internen Stellglieder je nach Ausführungsform Ablenkeinrichtungen für das Licht und/oder Verschiebeeinrichtungen der Probe und/oder Stellglieder in der Bildverarbeitungseinrichtung. Ein Stellglied in der Bildverarbeitungseinrichtung bezeichnet beispielsweise hier die Einflußnahme auf einen Parameter, der Auswirkungen auf die Berechnung des Bildes hat. Weiterhin kommen weitere Aktuatoren zum Einsatz, die schwingungsempfindlich sind, sowie Kraftaktuatoren (elektrodynamische Linearantriebe) und Wegantriebe (Piezotranslatoren).

**Patentansprüche**

1. Abbildende und/oder in einem Rastermodus abtastende Vorrichtung, insbesondere Rastermikroskop, umfassend:

    ein Probetisch mit einer Verschiebeeinrichtung für eine Probe,
    eine Probeabtasteinrichtung, die ein internes Stellglied (3) aufweist,
    eine Bilderfassungseinrichtung (7) zur Erfassung mindestens eines Bildpunktes eines Objektes,
    eine der Bilderfassungseinrichtung nachgeschaltete Bildverarbeitungseinrichtung (2), und
    eine Bilddarstellungseinrichtung, ferner
    eine Kompensationseinrichtung zur Kompensation von die Abbildung verschlechternden Störungen infolge Umgebungseinflüssen, die zumindest einen Sensor (4) zur Erfassung der Umgebungseinflüsse und ein elektrisches Filter (5) aufweist, wobei ein von den Umgebungseinflüssen abhängiges erstes Signal das Filter (5)

EP 1 018 136 B1

durchläuft und das interne Stellglied (3) ansteuert, das auf die Abbildung einwirkt,

**dadurch gekennzeichnet,**
**dass** das Filter (5) ein digitales Filter mit einstellbarer Übertragungskennlinie ist, das einen ersten oder Signaleingang und einen zweiten oder Einstelleingang aufweist, wobei im kalibrierten Zustand der Vorrichtung, welcher durch Einstellung der Übertragungskennlinie des Filters (5) gekennzeichnet ist, die Bildverschlechterung stark vermindert oder im wesentlichen kompensiert ist.

**2.** Vorrichtung nach Anspruch 1,
**dadurch gekennzeichnet, dass** das zweite am Einstelleingang des Filters anliegende Signal von der Bildverarbeitungsvorrichtung (2) gewonnen wird.

**3.** Vorrichtung nach Anspruch 1 oder 2,
**dadurch gekennzeichnet, dass** der Sensor (4) zur Erfassung von elektromagnetischen und/oder magnetischen Feldern ausgebildet ist.

**4.** Vorrichtung nach Anspruch 1 oder 2
**dadurch gekennzeichnet, dass** der Sensor (4) mindestens einen Aufnehmer für Luftschwingungen und/oder Bodenschwingungen umfasst.

**5.** Vorrichtung nach Anspruch 2,
**dadurch gekennzeichnet, dass** der Signaleingang des Filters (5) mit einem weiteren Ausgang der Bildverarbeitungseinrichtung (2) verbunden ist.

**6.** Vorrichtung nach Anspruch 1,
**gekennzeichnet durch** eine Einrichtung zur manuellen Kalibrierung des Filters (5).

**7.** Vorrichtung nach einem der vorstehenden Ansprüche,
**dadurch gekennzeichnet, dass** das interne Stellglied (3) in der Bildverarbeitungseinrichtung (21) angeordnet ist und zumindest ein Teil der Verschlechterung des in der Bildverarbeitungseinrichtung (21) verarbeiteten Bildes vermindert oder kompensiert ist.

**8.** Vorrichtung nach einem der vorstehenden Ansprüche,
**dadurch gekennzeichnet, dass** als das interne Stellglied (3) das Ablenksystem der Probeabtasteinrichtung fungiert.

**9.** Vorrichtung nach Anspruch 2
**dadurch gekennzeichnet,**
**dass** die Vorrichtung in einem Kalibrierbetrieb und nachfolgend in einem Bildbetrieb betreibbar ist,
wobei im Kalibrierbetrieb Umgebungseinflüsse, die die Abbildung verschlechtern, durch das Abbilden eines vorgegebenen Referenzobjektes und Vergleichen dessen Bildes mit der realen Struktur des Referenzobjektes in der Bildverarbeitungseinrichtung (2) erfasst und der Einfluss der Störungen durch Kalibrierung des Filters (5) stark vermindert oder im Wesentlichen kompensiert wird, und
wobei die Verschlechterung der Abbildung durch Beibehaltung der Kalibrierung im Bildbetrieb auch bei einer Veränderung der Umgebungseinflüsse kompensiert wird.

**10.** Vorrichtung nach Anspruch 9,
**dadurch gekennzeichnet, dass** im Kalibrierbetrieb:

die Abtasteinrichtung einen ausgewählten Abschnitt des Referenzobjektes abtastet,
die Bildverarbeitungseinrichtung (2) digital ist und ein gespeichertes, dem Referenzobjekt zugeordnetes Signal mit dem von der Bilderfassungseinrichtung (7) erhaltenen Bildsignal des Referenzobjektes vergleicht, ein dem Unterschied zugeordnetes Fehlersignal bildet und an das Filter (5) abgibt und
die Vorrichtung in einem Speicher Daten zur Erzeugung des zweiten Signals ablegt, das die Übertragungsparameter zur Einstellung der Übertragungskennlinie des Filters für den Bildbetrieb beinhaltet.

**11.** Vorrichtung nach Anspruch 9,
**dadurch gekennzeichnet, dass** im Bildbetrieb:

die Abtasteinrichtung das abzubildende Objekt abtastet und

die Vorrichtung unter Zugrundelegen der während des Kalibrierbetriebs abgespeicherten Daten das zweite Signal erzeugt, das die Übertragungsparameter des Filters beinhaltet.

12. Vorrichtung nach Anspruch 2,
**dadurch gekennzeichnet, dass** die Vorrichtung zur automatischen Kalibrierung des Filters (5) während des Bildbetriebs eingerichtet ist.

13. Vorrichtung nach Anspruch 12,
**dadurch gekennzeichnet, dass** die Bilderfassungseinrichtung (7) das abzubildende Objekt abtastet und dass die Bildverarbeitungseinrichtung (2) dafür eingerichtet ist, die Helligkeitsverteilung von Bildzeilen zu analysieren, daraus Zeilenschwerpunkte zu ermitteln und die Lage der Zeilenschwerpunkte zeitlich aufeinander folgender Bildzeilen innerhalb des Gesamtbildes festzustellen, um daraus die zeitliche Verschiebung dieser Zeilenschwerpunkte zu ermitteln, woraus das zweite Signal in Abhängigkeit dieser zeitlichen Verschiebung gebildet an das Filter (5) abgegeben wird.

14. Vorrichtung nach Anspruch 12,
**dadurch gekennzeichnet, dass** die Bildverarbeitungseinrichtung dafür eingerichtet ist, die Helligkeitsverteilung von Bildern zu analysieren, daraus Bildschwerpunkte zu ermitteln und die Lage der Bildschwerpunkte zeitlich aufeinander folgender Bilder festzustellen, um daraus die zeitliche Verschiebung dieser Bildschwerpunkte zu ermitteln, woraus das zweites Signal in Abhängigkeit dieser zeitlichen Verschiebung gebildet und an das Filter (5) abgegeben wird.

15. Vorrichtung nach einem der Ansprüche 12 bis 14,
**dadurch gekennzeichnet, dass** das Filter zur Durchführung einer Kreuzkorrelation des ersten Signals und des zweiten Signals eingerichtet ist.

16. Vorrichtung nach einem der Ansprüche 1 bis 15,
**dadurch gekennzeichnet, dass** die Kompensationseinrichtung in zwei zueinander orthogonalen Richtungen wirksam ist.

17. Vorrichtung nach einem der Ansprüche 1 bis 16 in einer Ausbildung als Elektronenmikroskop,
**dadurch gekennzeichnet, dass** das interne Stellglied (3) eine Ablenkeinrichtung des Elektronenstrahls umfasst.

18. Verfahren zum Betrieb einer abbildenden und/oder in einem Rastermodus abtastenden Vorrichtung nach einem der Ansprüche 1 bis 17,
**gekennzeichnet durch** folgende Schritte:

das zweite Signal wird dem Einstelleingang des Filters (5) zur Eingabe von Übertragungsparameter zugeführt, um eine zugeordnete Übertragungskennlinie des Filters (5) einzustellen und die Vorrichtung zu kalibrieren, das erste Signal wird dem Signaleingang des Filters (5) zur Bildung eines kompensierenden Ausgangssignals zugeführt, das das interne Stellglied (3) feingeregelt steuert, um die Probeabtasteinrichtung zu steuern und so die Verschlechterung der Abbildung infolge der Störung **durch** die Umwelteinflüsse zu kompensieren.

19. Verfahren nach Anspruch 18,
**dadurch gekennzeichnet, dass** das Kalibrieren der Vorrichtung durch manuelles Einstellen des Filters (5) durchgeführt wird.

20. Verfahren nach Anspruch 18,
**dadurch gekennzeichnet, dass** ein Stellglied in der Bildverarbeitungseinrichtung (2) gesteuert und die Kompensation der Bildverschlechterung zumindest teilweise in der Bildverarbeitungseinrichtung durchgeführt wird.

21. Verfahren nach Anspruch 18,
**dadurch gekennzeichnet, dass** die Vorrichtung in einem Kalibrier- und nachfolgend in einem Bildbetrieb betrieben wird, wobei

im Kalibrierbetrieb die Verschlechterung der Abbildung durch das Abbilden eines vorgegebenen Referenzobjektes und Vergleichen des Bildes mit der realen Struktur des Referenzobjektes erfasst und daraus Übertragungsparameter für das Filter (5) erzeugt werden, welche die Übertragungskennlinie des Filters so einstellen, dass die Verschlechterung der Abbildung stark vermindert oder im wesentlichen kompensiert wird und dass im Bildbetrieb Störungen infolge von Umgebungseinflüssen, die die Abbildung verschlechtern, mittels des Sensors (4) erfasst und dem Signaleingang des elektrischen Filters (5) zugeführt werden, wobei die Verschlechterung der Abbildung durch Beibehaltung der eingestellten Übertragungskennlinie des Filters auch bei Veränderung der Umgebungseinflüsse wenigstens teilweise kompensiert wird.

22. Verfahren nach Anspruch 21,
**dadurch gekennzeichnet, dass** der Kalibrierbetrieb wenigstens die Schritte umfasst:

Erzeugen des ersten Signals des Sensors (4), das vom Umgebungseinfluss am Ort des Sensors abhängt;
Anlegen des ersten Signals an den Signaleingang des Filters (5);
Erfassen eines ausgewählten Abschnittes (9) eines vorgegebenen Referenzobjektes mit der Bilderfassungseinrichtung (7) durch Abtasten des Referenzobjektes;
Vergleichen des erfassten Bildes mit der realen Struktur des Referenzobjektes;
Ermitteln eines dem Unterschied zugeordneten Fehlersignals und Bildung des zweiten Signals aus dem Fehlersignal;
Anlegen des zweiten Signals an den Einstelleingang des Filters (5) zur Einstellung der Übertragungskennlinie des Filters;
Anlegen des Ausgangssignals des Filters an den Signaleingang eines Regelverstärkers (6);
Anlegen des Ausgangssignals des Regelverstärkers an das interne Stellglied (3) im Hinblick auf Erzeugung einer Abbildung mit verbesserter Bildqualität;
iterative Einstellung der Übertragungskennlinie für verbesserte Abbildungsqualität durch die Schritte:

Vergleich der verbesserten Abbildung mit der realen Struktur des Referenzobjektes,
Bildung eines zweiten, verbesserten Signals,
erneutes Einstellen des Filters mit verbesserter Übertragungskennlinie des Filters, so dass sich die nochmals verbesserte Abbildung der realen Struktur des Referenzobjektes nähert,
Abspeichern von Daten zur Erzeugung der ermittelten Übertragungskennlinie des Filters für den Bildbetrieb.

23. Verfahren nach Anspruch 21,
**dadurch gekennzeichnet,**
**dass** im Bildbetrieb eine Probe durch Abtasten erfasst wird, wobei die im Kalibrierbetrieb ermittelte Übertragungskennlinie des Filters (5) der Vorrichtung fest vorgegeben wird, und das Ausgangssignal des digitalen Filters (5) nach Durchlaufen eines Regelverstärkers (6) dem internen Stellglied (3) zugeführt wird, so dass Verschlechterungen der Abbildung infolge von Störungen auch bei Veränderung der Umgebungseinflüsse stark vermindert oder im wesentlichen kompensiert werden.

24. Verfahren nach Anspruch 18,
**dadurch gekennzeichnet, dass**
die Bilderfassungseinrichtung die Bildverarbeitungseinrichtung (2) speist, in der eine Bildanalyse durchgeführt wird und ein von der Analyse abhängiges Signal als zweites Signal an den Einstelleingang des Filters (5) angelegt wird,
das Ausgangssignal des Filters (5) über einen Regelverstärker (6) an einem Aktuator und/oder einem Stellglied (3) der Vorrichtung angelegt wird, um auf die Abbildung einzuwirken und die Verschlechterung der Abbildung infolge der Störung zu vermeiden oder zu kompensieren.

25. Verfahren nach Anspruch 24,
auszuführen mit einer Vorrichtung nach Anspruch 14,
**dadurch gekennzeichnet, dass**
das abzubildende Objekt durch die Bilderfassungseinrichtung abgetastet wird,
die Bildanalyse die rekursive Bestimmung der Verschiebung von Zeilenschwerpunkten von zeitlich aufeinander folgenden Bildzeilen innerhalb des Gesamtbildes umfasst, und dass
das zweite Signal aus dieser zeitlichen Verschiebung berechnet wird.

26. Verfahren nach Anspruch 24,
auszuführen mit einer Vorrichtung gemäss Anspruch 15,
**dadurch gekennzeichnet, dass**

EP 1 018 136 B1

die Bildanalyse die rekursive Bestimmung der Verschiebung von Bildschwerpunkten gemäss Anspruch 15 von zeitlich aufeinander folgenden Bilder umfasst, und

das zweite Signal aus dieser zeitlichen Verschiebung berechnet wird.

**27.** Verfahren nach einem der Ansprüche 25 oder 26,
**dadurch gekennzeichnet, dass** im Filter (5) im wesentlichen die Kreuzkorrelation des ersten Signals mit dem zweiten Signal durchgeführt wird und das interne Stellglied (3) mit einem Ausgangssignal des Filters gesteuert wird, welches von der Kreuzkorrelation zwischen dem ersten Signal und zweiten Signal abhängt.

**28.** Verfahren nach Anspruch 18,
**dadurch gekennzeichnet, dass**
die Bilderfassungseinrichtung (7) die Bildverarbeitungseinrichtung (2) speist, dass
in der Bildverarbeitungseinrichtung (2) eine Bildanalyse durchgeführt wird und
ein von der Bildanalyse abhängiges Signal als erstes Signal an den Signaleingang des Filters (5) angelegt wird, sowie
ein von der Bildanalyse abhängiges Signal als zweites Signal an den Einstelleingang des Filters (5) angelegt wird,
das Ausgangssignal des Filters (5) über einen Regelverstärker (6) wenigstens das interne Stellglied (3) steuert, um die Verschlechterung der infolge der Störung zu mindern oder im Wesentlichen zu kompensieren.

**29.** Verfahren nach Anspruch 25,
auszuführen mit einer Vorrichtung gemäss Anspruch 14 oder gemäss Anspruch 15,
**dadurch gekennzeichnet, dass** die Bildanalyse die rekursive Bestimmung der Verschiebung von Zeilenschwerpunkten von zeitlich aufeinander folgenden Bildzeilen innerhalb des Gesamtbildes oder die rekursive Bestimmung der Verschiebung von Bildschwerpunkten von zeitlich aufeinander folgenden Bilder umfasst.

**30.** Verfahren nach einem der vorstehenden Verfahrensansprüche,
**dadurch gekennzeichnet, dass** zwei in zueinander orthogonalen Richtungen wirkende interne Stellglieder (3) benutzt werden, um die Verschlechterung der Abbildung infolge Störungen zu kompensieren.

**Claims**

**1.** An imaging device and/or a device operating in a raster scanning mode, particularly a scanning microscope, comprising:

a sample table with a displacement device for a sample,

a sample scanning device having an internal control element (3),

an image acquisition device (7) for acquisition of at least one pixel of an object,

an image processing device (2) connected downstream of the image acquisition device, and

an image display device, and also

a compensation device for compensating disturbances which impair the imaging due to environmental influences, said compensation device comprising at least one sensor (4) for detecting the environmental influences and an electric filter (5),

wherein a first signal dependent on the environmental influences passes through the filter (5) and actuates the internal control element (3) which acts on the image, **characterised in that**
the filter (5) is a digital filter with an adjustable transmission characteristic and having a first or signal input and a second or setting input, wherein in the calibrated state of the device as **characterised by** setting of the transmission characteristic of the filter (5) the image deterioration is greatly reduced or substantially compensated.

**2.** A device according to claim 1, **characterised in that** the second signal at the filter setting input is obtained from the image processing device (2).

12

3. A device according to claim 1 or 2, **characterised in that** the sensor (4) is constructed to detect electromagnetic and/or magnetic fields.

4. A device according to claim 1 or 2, **characterised in that** the sensor (4) comprises at least one pick-up for air vibrations and/or ground vibrations.

5. A device according to claim 2, **characterised in that** the signal input of the filter (5) is connected to another output of the image processing device (2).

6. A device according to claim 1, **characterised by** a device for manual calibration of the filter (5).

7. A device according to any of one of the preceding claims, **characterised in that** the internal control element (3) is disposed in the image processing device (21) and at least a part of the deterioration of the image processed in the imaging processing device (21) is reduced or compensated.

8. A device according to any one of the preceding claims, **characterised in that** the deflection system of the sample scanning device functions as the internal control element (3).

9. A device according to claim 2, **characterised in that** the device is adapted to operate in a calibration mode and then in an image mode,
wherein in the calibration mode environmental influences which impair the imaging are detected by imaging of a preset reference object and comparison of the image thereof with the real structure of the reference object in the image processing device (2) and the influence of the disturbances is greatly reduced or substantially compensated by calibration of the filter (5), and
wherein the deterioration of the imaging is compensated by maintaining the calibration in the image mode even in the event of a change of the environmental influences.

10. A device according to claim 9, **characterised in that** in the calibration mode:

   the scanning device scans a selected portion of the reference object,

   the image processing device (2) is digital and compares a stored signal associated with the reference object with the image signal of the reference object obtained by the image acquisition device (7), forms an error signal associated with the difference and delivers it to the filter (5) and

   the device files in a memory data for generating the second signal which contains the transmission parameters for setting the transmission characteristic of the filter for the image mode.

11. A device according to claim 9, **characterised in that** in the image mode:

   the scanning device scans the object for imaging and

   the device on the basis of the data stored during the calibration mode generates the second signal containing the transmission parameters of the filter.

12. A device according to claim 2, **characterised in that** the device is adapted to automatic calibration of the filter (5) during the image mode.

13. A device according to claim 12, **characterised in that** the image acquisition device (7) scans the object for imaging and **in that** the image processing device (2) is adapted to analyse the brightness distribution of image lines, determine therefrom line centres of gravity and establish the position of the centres of gravity of image lines following one another per unit of time within the overall picture in order to determine therefrom the shift per unit of time of these line centres of gravity, from which the second signal formed in dependence on this time shift is delivered to the filter (5).

14. A device according to claim 12, **characterised in that** the image processing device is adapted to analyse the brightness distribution of images, determine therefrom image centres of gravity and establish the position of the centres of gravity of images following one another per unit of time in order to determine therefrom the shift per unit of time of these image centres of gravity, from which the second signal is formed in dependence on this time shift and is delivered to the filter (5).

**15.** A device according to any one of claims 12 to 14, **characterised in that** the filter is adapted to perform a cross-correlation of the first signal and of the second signal.

**16.** A device according to any one of claims 1 to 15, **characterised in that** the compensation device is operative in two directions at right angles to one another.

**17.** A device according to any one of claims 1 to 16, in a construction as an electron microscope, **characterised in that** the internal control element (3) comprises a deflection device for the electron beam.

**18.** A method of operating an imaging device and/or a device operating in a raster scanning mode, in accordance with any one of claims 1 to 17,
**characterised by** the following steps:

the second signal is fed to the setting input of the filter (5) in order to input transmission parameters, set an associated transmission characteristic of the filter (5), and calibrate the device,

the first signal is fed to the signal input of the filter (5) to form a compensating output signal which controls the internal control element (3) with fine adjustment in order to control the sample scanning device and thus compensate for the deterioration of the imaging due to disturbance by environmental influences.

**19.** A device according to claim 18, **characterised in that** the calibration of the device is performed by manual setting of the filter (5).

**20.** A device according to claim 18, **characterised in that** a control element in the image processing device (2) is controlled and the compensation of the image deterioration is at least partially performed in the image processing device.

**21.** A device according to claim 18, **characterised in that** the device is operated in a calibration mode and then in an image mode, wherein
in the calibration mode: the deterioration of the imaging is detected by imaging a preset reference object and comparison of the image with the real structure of the reference object and transmission parameters for the filter (5) are generated therefrom and so set the transmission characteristic of the filter that the deterioration of the imaging is greatly reduced or substantially compensated and **in that**
in the image mode: disturbances due to environmental influences which impair the image are detected by means of the sensor (4) and fed to the signal input of the electric filter (5), the deterioration of the imaging being at least partially compensated by retaining the set transmission characteristic of the filter even in the event of a change of environmental influences.

**22.** A device according to claim 21, **characterised in that** the calibration mode comprises at least the steps:

generation of the first signal of the sensor (4) depending upon the environmental influence at the sensor location;

application of the first signal to the signal input of the filter (5);

detection of a selected portion (9) of a preset reference object with the image acquisition device (7) by scanning the reference object (7);

comparison of the detected image with the real structure of the reference object;

determining an error signal associated with the difference and forming the second signal from the error signal;

application of the second signal to the setting input of the filter (5) to set the transmission characteristic of the filter;

application of the output signal of the filter to the signal input of a control amplifier (6);

application of the output signal of the control amplifier to the internal control element (3) for the purpose of generating an image with improved image quality;

iterative setting of the transmission characteristic for improved imaging quality by the steps:

comparison of the improved imaging with the real structure of the reference object,

formation of a second improved signal,

re-setting of the filter with improved transmission characteristic of the filter so that the imaging improved again approaches the real structure of the reference object,

storage of data for generating the determined transmission characteristic of the filter for the image mode.

23. A method according to claim 21, **characterised in that**
in the image mode: a sample is detected by scanning, wherein the transmission characteristic of the filter (5) as determined in the calibration mode is preset as a fixed value for the device and the output signal of the digital filter (5) after passing through a control amplifier (6) is fed to the internal control element (3) so that deterioration of the imaging due to disturbances is greatly reduced or substantially compensated even in the event of a change of the environmental influences.

24. A method according to claim 18, **characterised in that** the image acquisition device feeds the image processing device (2) in which an image analysis is performed and a signal dependent on the analysis is applied as second signal to the setting input of the filter (5),
the output signal of the filter (5) is applied via a control amplifier (6) to an actuator and/or a control element (3) of the device in order to act on the imaging and prevent or compensate for deterioration of the imaging due to the disturbance.

25. A method according to claim 24, to be performed with a device according to claim 14, **characterised in that**
the object for imaging is scanned by the image acquisition device,
the image analysis comprises recursive determination of the shift of centres of gravity of image lines following one another per unit of time within the overall image, and
**in that** the second signal is calculated from said time shift.

26. A method according to claim 24, to be performed with a device according to claim 15, **characterised in that**
the image analysis comprises the recursive determination of the shift of centres of gravity in accordance with claim 15, of images following one another per unit of time, and
the second signal is calculated from said time shift.

27. A method according to claim 25 or 26, **characterised in that** in the filter (5) the cross-correlation of the first signal with the second signal is performed substantially and the internal control element (3) is controlled with an output signal of the filter which depends on the cross-correlation between the first signal and the second signal.

28. A method according to claim 18, **characterised in that** the image acquisition device (7) feeds the image processing device (2), **in that**
an image analysis is performed in the image processing device (2) and
a signal dependent on the image analysis is applied as first signal to the signal input of the filter (5) and
a signal dependent on the image analysis is applied as second signal to the setting input of the filter (5),
the output signal of the filter (5) by means of a control amplifier (6) controls at least the internal control element (3) in order to reduce or substantially compensate for the deterioration due to the disturbance.

29. A method according to claim 25, to be performed with a device according to claim 14 or according to claim 15, **characterised in that** the image analysis comprises recursive determination of the shift of centres of gravity of image lines following one another per unit of time within the overall image or recursive determination of the shift of centres of gravity of images following one another per unit of time.

**30.** A method according to any one of the preceding method claims, **characterised in that** use is made of two internal control elements (3) acting in directions at right angles to one another in order to compensate for the deterioration of the imaging due to disturbances.

## Revendications

**1.** Dispositif d'imagerie et/ou d'exploration en un mode trame, en particulier microscope à balayage, comprenant :

une table à échantillon avec un dispositif de déplacement pour un échantillon,
un dispositif d'exploration d'échantillon qui présente un organe interne de réglage (3),
un dispositif d'acquisition d'image (7) pour acquérir au moins un point d'image d'un objet,
un dispositif de traitement d'image (2) raccordé en aval du dispositif d'acquisition d'image et un dispositif de représentation d'image,
en outre un dispositif de compensation pour compenser les perturbations dégradant l'image en raison d'influences de l'environnement, qui présente au moins un capteur (4) pour l'acquisition des influences de l'environnement et un filtre électrique (5), un premier signal dépendant des influences de l'environnement traversant le filtre (5) et commandant l'organe interne de réglage (3) qui influe sur l'imagerie,

**caractérisé en ce que**,
le filtre (5) est un filtre numérique dont la courbe caractéristique de transfert est réglable, qui présente une première entrée ou entrée de signal et une deuxième entrée ou entrée de réglage, où, en l'état étalonné du dispositif, qui est **caractérisé par** le réglage de la courbe caractéristique de transfert du filtre (5), la dégradation de l'image est fortement diminuée ou, pour l'essentiel, compensée.

**2.** Dispositif selon la revendication 1, **caractérisé en ce que** le deuxième signal figurant à l'entrée de réglage du filtre provient du dispositif de traitement d'image (2).

**3.** Dispositif selon la revendication 1 ou 2, **caractérisé en ce que** le détecteur (4) est constitué pour acquérir des champs électromagnétiques et/ou magnétiques.

**4.** Dispositif selon la revendication 1 ou 2, **caractérisé en ce que** le détecteur (4) comprend au moins un enregistreur d'oscillations de l'air et/ou d'oscillations du sol.

**5.** Dispositif selon la revendication 2, **caractérisé en ce que** l'entrée de signal du filtre (5) est reliée à une autre sortie du dispositif de traitement d'image (2).

**6.** Dispositif selon la revendication 1, **caractérisé par** un dispositif d'étalonnage manuel du filtre (5).

**7.** Dispositif selon l'une quelconque des revendications précédentes, **caractérisé en ce que** l'organe de réglage interne (3) est disposé dans le dispositif de traitement d'image (21) et diminue ou compense au moins une partie de la dégradation de l'image traitée dans le dispositif de traitement d'image (21).

**8.** Dispositif selon l'une quelconque des revendications précédentes, **caractérisé en ce que** le système de déviation du dispositif d'exploration d'échantillon fonctionne en tant qu'organe de réglage interne (3).

**9.** Dispositif selon la revendication 2, **caractérisé en ce que** le dispositif peut être exploité en un mode étalonnage et ensuite en un mode image, dans lequel, en mode étalonnage, des influences de l'environnement qui dégradent l'imagerie sont acquises dans le dispositif de traitement d'image (2) par la représentation d'un objet de référence prédéterminé et la comparaison de son image avec la structure réelle de l'objet de référence, et l'influence des perturbations est fortement diminuée ou, pour l'essentiel, compensée par étalonnage du filtre (5), et dans lequel la dégradation de l'image est également compensée lors d'une modification des influences de l'environnement en conservant l'étalonnage en mode image.

**10.** Dispositif selon la revendication 9, **caractérisé en ce que**, en mode étalonnage :

le dispositif d'exploration explore une section sélectionnée de l'objet de référence,
le dispositif de traitement d'image (2) est numérique et compare un signal stocké associé à l'objet de référence avec le signal image de l'objet de référence reçu du dispositif d'acquisition d'image (7), forme un signal d'erreur associé à cette différence et le délivre au filtre (5) et le dispositif dépose dans une mémoire des données pour générer le deuxième signal qui contient les paramètres de transfert pour régler la courbe caractéristique de transfert du filtre pour le mode image.

11. Dispositif selon la revendication 9, **caractérisé en ce que**, en mode image :

le dispositif d'exploration explore l'objet à représenter,
le dispositif, en se reposant sur les données stockées pendant le mode étalonnage génère le deuxième signal qui contient les paramètres de transfert du filtre.

12. Dispositif selon la revendication 2, **caractérisé en ce que** le dispositif est constitué pour étalonner automatiquement le filtre (5) en mode image.

13. Dispositif selon la revendication 12, **caractérisé en ce que** le dispositif d'acquisition d'image (7) explore l'objet à représenter et que le dispositif de traitement d'image (2) est constitué pour analyser la répartition de la luminosité dans des lignes image, d'en déterminer des points forts de ligne et de définir la position à l'intérieur de l'image complète des points forts de ligne de lignes image se succédant dans le temps de façon à en déduire le décalage dans le temps de ces points forts d'image, ce à partir de quoi, le deuxième signal élaboré en fonction de ce décalage dans le temps est délivré au filtre (5).

14. Dispositif selon la revendication 12, **caractérisé en ce que** le dispositif de traitement d'image est constitué pour analyser la répartition de la luminosité dans des images, en déterminer des points forts d'image et définir la position des points forts d'images se succédant dans le temps de façon à en déduire le décalage dans le temps de ces points forts d'image, ce à partir de quoi, le deuxième signal élaboré en fonction de ce décalage dans le temps est délivré au filtre (5).

15. Dispositif selon l'une quelconque des revendications 12 à 14, **caractérisé en ce que** le filtre est constitué pour exécuter une corrélation croisée du premier signal et du deuxième signal.

16. Dispositif selon l'une quelconque des revendications 1 à 15, **caractérisé en ce que** le dispositif de compensation agit en deux directions orthogonales l'une par rapport à l'autre.

17. Dispositif selon l'une quelconque des revendications 1 à 16 en une configuration en tant que microscope électronique, **caractérisé en ce que** l'organe interne de réglage (3) comprend un dispositif de déviation du faisceau électronique.

18. Procédé d'exploitation d'un dispositif d'imagerie et/ou d'exploration en un mode trame selon l'une quelconque des revendications 1 à 17, **caractérisé par** les étapes suivantes:

le deuxième signal est conduit à l'entrée de réglage du filtre (5) pour l'introduction des paramètres de transfert pour régler une courbe associée caractéristique de transfert du filtre (5) et pour étalonner le dispositif, le premier signal est conduit à l'entrée de signal du filtre (5) pour former un signal de sortie de compensation qui commande l'organe interne de réglage (3) en régulation fine pour commander le dispositif d'exploration d'échantillon et ainsi compenser la dégradation de l'imagerie en raison de perturbations par les influences de l'environnement.

19. Procédé selon la revendication 18, **caractérisé en ce que** l'étalonnement du dispositif est réalisé par réglage manuel du filtre (5).

20. Procédé selon la revendication 18, **caractérisé en ce qu'**un organe de réglage est commandé dans le dispositif de traitement d'image (2) et que la compensation de la dégradation de l'image est réalisée au moins partiellement dans le dispositif de traitement d'image.

21. Procédé selon la revendication 18, **caractérisé en ce que** le dispositif est exploité en un mode étalonnage et ensuite en un mode image, dans lequel, en mode étalonnage, la dégradation de l'imagerie est acquise par la représentation d'un objet de référence prédéterminé et la comparaison de l'image avec la structure réelle de l'objet et que des paramètres de transfert pour le filtre (5) en sont générés qui règlent la courbe caractéristique de transfert du filtre de manière telle que la dégradation de l'imagerie est fortement diminuée ou, pour l'essentiel, compensée et que des perturbations en mode image du fait d'influences de l'environnement qui dégradent la représentation sont acquises au moyen du capteur (4) et conduites à l'entrée de signal du filtre électrique (5), la dégradation de l'imagerie étant au moins partiellement compensée également lors d'une modification des influences de l'environnement par la conservation de la courbe caractéristique réglée de transfert du filtre.

**22.** Procédé selon la revendication 21, **caractérisé en ce que** le mode étalonnage comprend au moins trois étapes :

génération du premier signal du capteur (4) qui dépend de l'influence de l'environnement à l'emplacement du capteur ;
application du premier signal à l'entrée de signal du filtre (5) ;
acquisition avec le dispositif d'acquisition d'image (7) d'une section sélectionnée (9) d'un objet de référence prédéfini, par exploration de l'objet de référence ;
comparaison de l'image acquise avec la structure réelle de l'objet de référence ;
détermination d'un signal d'erreur associé à la différence et formation du deuxième signal à partir du signal d'erreur ;
application du deuxième signal à l'entrée de réglage du filtre (5) pour le réglage de la courbe caractéristique de transfert du filtre ;
application du signal de sortie du filtre à l'entrée de signal d'un amplificateur de régulation (6) ;
application du signal de sortie de l'amplificateur de régulation à l'organe interne de réglage (3) avec, en vue, la génération d'une imagerie avec qualité d'image améliorée ;
réglage itératif de la courbe caractéristique de transfert pour une qualité améliorée d'imagerie par les étapes suivantes :

comparaison de l'imagerie améliorée avec la structure réelle de l'objet de référence,
formation d'un deuxième signal amélioré,
nouveau réglage du filtre avec la courbe caractéristique de transfert améliorée du filtre, si bien que l'imagerie de nouveau améliorée s'approche de la structure réelle de l'objet de référence,
stockage de données pour générer la courbe caractéristique de transfert du filtre pour le mode image.

**23.** Procédé selon la revendication 21, **caractérisé en ce que**, en mode image un échantillon est acquis par exploration, la courbe caractéristique de transfert du filtre (5) déterminée en mode étalonnage est prescrite de manière fixe au dispositif et le signal de sortie du filtre numérique (5) est conduit à l'organe interne de réglage (3) après avoir traversé un amplificateur de régulation (6), si bien que la dégradation de l'imagerie en raison de perturbations est fortement réduite ou, pour l'essentiel, compensée, également en cas de modification des influences de l'environnement.

**24.** Procédé selon la revendication 18, **caractérisé en ce que** le dispositif d'acquisition d'image alimente le dispositif de traitement d'image (2) dans lequel une analyse d'image est effectuée et un signal dépendant de l'analyse est appliqué en tant que deuxième signal à l'entrée de réglage du filtre (5), le signal de sortie du filtre (5) est appliqué à un actionneur et/ou un organe de réglage (3) du dispositif au travers d'un amplificateur de régulation (6) de façon à agir sur l'imagerie et empêcher ou compenser la dégradation de l'imagerie en raison de la perturbation.

**25.** Procédé selon la revendication 24, à exécuter avec un dispositif selon la revendication 14, **caractérisé en ce que** l'objet à reproduire est exploré par le dispositif d'acquisition d'image, l'analyse d'image englobe la détermination récursive du décalage de points forts d'image de lignes d'image se succédant dans le temps à l'intérieur de la totalité de l'image et que le deuxième signal est calculé à partir de ce décalage dans le temps.

**26.** Procédé selon la revendication 24, à exécuter avec un dispositif selon la revendication 15, **caractérisé en ce que** l'analyse d'image englobe la détermination récursive du décalage de points forts d'image selon la revendication 15 de lignes d'image se succédant dans le temps et que le deuxième signal est calculé à partir de ce décalage dans le temps.

**27.** Procédé selon l'une quelconque des revendications 25 ou 26, **caractérisé en ce que**, pour l'essentiel, la corrélation croisée du premier signal et du deuxième signal est réalisée dans le filtre (5) et que l'organe de réglage interne (3) est commandé par un signal de sortie du filtre qui dépend de la corrélation croisée entre le premier signal et le deuxième signal.

**28.** Procédé selon la revendication 18, **caractérisé en ce que** le dispositif d'acquisition d'image (7) alimente le dispositif de traitement d'image (2), qu'une analyse d'image est réalisée dans le dispositif de traitement d'image (2) et qu'un signal dépendant de l'analyse d'image est appliqué en tant que premier signal à l'entrée de signal du filtre (5) de même qu'un signal dépendant de l'analyse d'image est appliqué en tant que deuxième signal à l'entrée de réglage du filtre (5), que le signal de sortie du filtre (5) commande au moins l'organe interne de réglage (3) au travers d'un amplificateur de réglage (6) de façon à diminuer ou compenser pour l'essentiel la dégradation suite à la perturbation.

**29.** Procédé selon la revendication 25 à exécuter avec un dispositif selon la revendication 14 ou selon la revendication 15, **caractérisé en ce que** l'analyse d'image englobe la détermination récursive du décalage de points forts d'image de lignes d'image se succédant dans le temps à l'intérieur de l'image complète ou la détermination récursive du décalage de points forts d'image, d'images se succédant dans le temps.

**30.** Procédé selon l'une quelconque des revendications de procédé précédentes, **caractérisé en ce que**, pour compenser la dégradation de l'imagerie à la suite de perturbations, deux organes de réglage interne (3) agissant dans des directions orthogonales l'une par rapport à l'autre sont utilisés.

a)

b)

c)

d)

Fig. 1

EP 1 018 136 B1

Fig. 2

21

Fig. 3

Fig 4

Fig 5

EP 1 018 136 B1

a)

16

y0

x0

b)

16

y1

x1

c)

16

y2

x2

Fig 6

Fig 7

**Fig. 8**